(19) Europäisches Patentamt / European Patent Office / Office européen des brevets

(11) EP 3 581 622 B1

(12) # EUROPEAN PATENT SPECIFICATION

(45) Date of publication and mention of the grant of the patent:
**26.07.2023 Bulletin 2023/30**

(21) Application number: **18750780.1**

(22) Date of filing: **07.02.2018**

(51) International Patent Classification (IPC):
***C08L 101/12*** (2006.01) ***C08F 26/10*** (2006.01)
***C08G 73/02*** (2006.01) ***C08L 39/06*** (2006.01)
***C08L 79/00*** (2006.01) ***C09D 5/02*** (2006.01)
***C09D 5/24*** (2006.01) ***C09D 139/06*** (2006.01)
***C09D 201/02*** (2006.01) ***H01B 1/20*** (2006.01)
***H01B 13/00*** (2006.01) ***C08L 65/00*** (2006.01)
***C09D 165/00*** (2006.01) ***G03F 7/09*** (2006.01)
***H01B 1/12*** (2006.01)

(52) Cooperative Patent Classification (CPC):
(C-Sets available)
**C08L 65/00; C08F 26/10; C08G 73/02; C08L 39/06; C08L 79/00; C08L 101/12; C09D 5/02; C09D 5/24; C09D 139/06; C09D 201/02; G03F 7/093; G03F 7/2059; G03F 7/2065; H01B 1/125; H01B 1/127;** (Cont.)

(86) International application number:
**PCT/JP2018/004188**

(87) International publication number:
**WO 2018/147318 (16.08.2018 Gazette 2018/33)**

(54) **CONDUCTIVE COMPOSITION, METHOD FOR PRODUCING CONDUCTIVE COMPOSITION, AND METHOD FOR PRODUCING CONDUCTOR**

LEITFÄHIGE ZUSAMMENSETZUNG, VERFAHREN ZUR HERSTELLUNG EINER LEITFÄHIGEN ZUSAMMENSETZUNG UND VERFAHREN ZUR HERSTELLUNG EINES LEITERS

COMPOSITION CONDUCTRICE AINSI QUE PROCÉDÉ DE FABRICATION DE CELLE-CI, ET PROCÉDÉ DE FABRICATION DE CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.02.2017 JP 2017022859**
**07.09.2017 JP 2017172284**

(43) Date of publication of application:
**18.12.2019 Bulletin 2019/51**

(73) Proprietor: **Mitsubishi Chemical Corporation**
**Tokyo 100-8251 (JP)**

(72) Inventors:
- **YAMAZAKI Akira**
  **Tokyo 100-8251 (JP)**
- **SAIKI Shinji**
  **Tokyo 100-8251 (JP)**
- **IRIE Yoshiko**
  **Tokyo 100-8251 (JP)**
- **UZAWA Masashi**
  **Tokyo 100-8251 (JP)**

(74) Representative: **Hoffmann Eitle**
**Patent- und Rechtsanwälte PartmbB**
**Arabellastraße 30**
**81925 München (DE)**

(56) References cited:
**WO-A1-2014/017540**
**WO-A1-2015/060231**
**JP-A- 2002 226 721**
**JP-A- 2014 009 342**
**JP-A- 2015 221 871**
**JP-A- 2016 102 190**
**JP-A- 2016 135 839**
**JP-A- 2017 095 589**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**JP-A- 2017 112 051** **JP-A- 2017 179 324**
**US-A1- 2016 091 792**

(52) Cooperative Patent Classification (CPC): (Cont.)
**H01B 1/20; H01B 13/00;** C08G 2261/1424;
C08G 2261/3223

C-Sets
**C08L 101/12, C08L 101/14;**
**C09D 165/00, C08L 39/06**

## Description

TECHNICAL FIELD

The present invention relates to a conductive composition, a method for producing a conductive composition, and a method for producing a conductor.

BACKGROUND ART

Pattern formation techniques using charged particle beams such as electron beams and ion beams are promising candidates of the next generation technology of photolithography. For improving the productivity with the use of charged particle beams, it is important to improve the sensitivity of the resist.

From this perspective, the mainstream process uses a highly sensitive chemically amplified resist that is allowed to generate an acid in its area exposed to light or irradiated with the charged particle beam and subsequently subjected to heat treatment (PEB: post exposure bake) to accelerate crosslinking reaction or decomposition reaction.

Incidentally, especially when the substrate is insulating, the method using charged particle beams has a problem that the trajectory of the charged particle beam is bent due to an electric field generated by the charge (charge up) of the substrate, resulting in difficulty in obtaining a desired pattern.

As a means to solve this problem, it is already known that a technique of applying a conductive composition containing a conductive polymer to a resist surface to form a coating to impart an antistatic function to the resist is effective.

In general, when a conductive composition containing a conductive polymer is applied as an antistatic agent in an electron beam lithography process for a semiconductor, there is a trade-off relationship between the ease in application of the conductive composition and the influence thereof on a substrate or a coating layer such as a resist coated on the substrate.

For example, the addition of an additive such as a surfactant for improving the ease in application of the conductive composition poses a problem that the surfactant adversely affects the resist characteristics and a predetermined pattern cannot be obtained.

Addressing such a problem, Patent Document 1 proposes a conductive composition including a water-soluble polymer having hydrophobic terminal groups as a conductive composition that excels in ease in application and the like.

On the other hand, when the conductive composition described above contains foreign matters, problems arise, such as defects in patterns after electron beam lithography. Therefore, the conductive composition is subjected to microfiltration, but the conductive composition of Patent Document 1 causes filter clogging during the microfiltration, which causes a problem that frequent filter replacement is necessitated. Further, Patent Document 2 implements an improvement to decrease the frequency of filter replacement at the time of the microfiltration of the conductive composition, but has a problem that the filtration time increases in proportion to the amount of the conductive composition flown through the filter.

JP 2015-221871 relates to a fluid dispersion of an electroconductive polymer/polyanion-based complex capable of forming a membrane (for example, a hole injection layer). Part or all of the polyanion in the complex is neutralized by either a nitrogen-containing heteroaromatic compound or amine having hydroxyl, and has a pH of 7 or less when a solid content concentration is 1.5 mass%.

US 2016/091792 concenrs a conductive polymer composition which contains (A) a polyaniline-based conductive polymer having a repeating unit represented by a certain general formula, (B) a polyanion, and (C) an amino acid. The conductive polymer composition is said to have excellent antistatic performance and applicability, to not adversely affect a resist, and to be useful in lithography using electron beam or the like.

Description of Prior Art

Patent Document

Patent Document 1: Japanese Unexamined Patent Application Publication No. 2002-226721
Patent Document 2: International Patent Application Publication No. 2014/017540

DISCLOSURE OF INVENTION

Problems to be Solved by the Invention

The recent trend of scale-down of semiconductor devices has made it necessary to manage resist shapes on the order of several nanometers. As an antistatic agent applicable even to the next-generation process for such semiconductor devices, it is desired to develop a conductive composition with less frequency of filter replacement in microfiltration, less filter clogging and less foreign matter content.

The present invention has been made in view of the above circumstances, and the purpose of the present invention is to provide a conductive composition which requires less time for filtration, a method for producing the conductive composition, and a method for producing a conductor, in which the conductive composition is applied to a substrate to form a coating.

Means to Solve the Problems

The embodiments of the present invention are as follows.

[1] A conductive composition including a conductive polymer (A), a water-soluble polymer (B) other than the conductive polymer (A), and a solvent (C), wherein the conductive polymer (A) is a water-soluble or water-dispersible conductive polymer and has at least one of a sulfonic acid group and a carboxy group,

the water-soluble polymer (B) is a homopolymer of a vinyl monomer having an amide bond, or a compound having a main chain structure formed of a copolymer of a vinyl monomer having an amide bond and a vinyl monomer having no amide bond, and has a terminal hydrophobic group of 4 or more carbon atoms in its molecule, the solvent (C) is water or a mixed solvent of water and an organic solvent,

wherein a peak area ratio is 0.44 or less, which is determined based on results of analysis performed using a high performance liquid chromatograph mass spectrometer with respect to a test solution obtained by extracting the water-soluble polymer (B) from the conductive composition with n-butanol, and calculated by formula (I):

$$\text{Area ratio} = Y/(X + Y) \qquad (I),$$

wherein X is a total peak area of an extracted ion chromatogram prepared with respect to ions derived from compounds having a molecular weight (M) of 600 or more from a total ion current chromatogram, Y is a total peak area of an extracted ion chromatogram prepared with respect to ions derived from compounds having a molecular weight (M) of less than 600 from the total ion current chromatogram.

[2] The conductive composition according to [1], wherein the water-soluble polymer (B) satisfies condition 2: an in-liquid particle number of not more than 5000 particles/ml of liquid as measured with respect to particles having a size of 0.5 to 1 μm in an aqueous solution containing 0.2 % by mass of the water-soluble polymer (B) and 99.8 % by mass of ultrapure water by a liquid particle counter, as determined further below in the description.

[3] The conductive composition according to [1] or [2], wherein the water-soluble polymer (B) has a weight average molecular weight of 600 or more and less than 2000, as determined further below in the description.

[4] The conductive composition according to any one of [1] to [3], wherein the conductive polymer (A) has a monomer unit represented by formula (1):

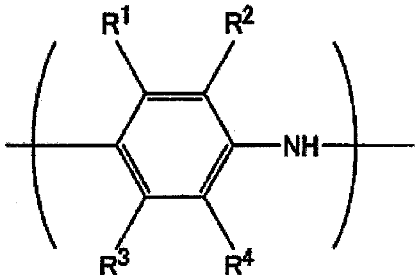

----- (1)

wherein each of $R^1$ to $R^4$ independently represents a hydrogen atom, a linear or branched alkyl group having 1 to 24 carbon atoms, a linear or branched alkoxy group having 1 to 24 carbon atoms, an acidic group, a hydroxy group,

a nitro group or a halogen atom (-F, -Cl -Br or I), with the proviso that at least one of $R^1$ to $R^4$ is an acidic group or a salt thereof, and the acidic group is a sulfonic acid group or a carboxylic acid group.

[5] The conductive composition according to any one of [1] to [4], wherein the water-soluble polymer (B) is a compound represented by formula (2):

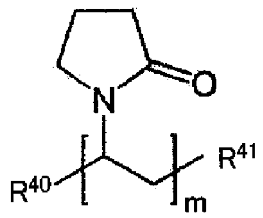

----- (2)

wherein each of $R^{40}$ and $R^{41}$ independently represents an alkylthio group, an aralkylthio group, an arylthio group or a hydrocarbon group, with the proviso that at least one of $R^{40}$ and $R^{41}$ is an alkylthio group, an aralkylthio group or an arylthio group; and m represents an integer of 2 to 100000.

[6] A method for producing the conductive composition of any one of [1] to [5], which comprises a step of purifying the water-soluble polymer (B) by at least one of processes (i) and (ii):

(i): a process of washing a solution containing the water-soluble polymer (B) with a solvent, and
(ii): a process of filtering a solution containing the water-soluble polymer (B) through a filter,

wherein the water-soluble polymer (B) is obtained by polymerizing a vinyl monomer having an amide bond in the presence of a polymerization initiator and a chain transfer agent having 4 or more carbon atoms; and and wherein the step of purifying the water-soluble polymer (B) precedes the mixing of the components of the conductive composition.

[7] A method for producing a conductor, which includes applying the conductive composition of any one of [1] to [5] to at least one surface of a substrate to form a coating.

Effect of the Invention

The present invention can provide a conductive composition which requires less time for filtration, a method for producing the conductive composition, and a method for producing a conductor, in which the conductive composition is applied to a substrate to form a coating.

DESCRIPTION OF THE EMBODIMENTS

Hereinbelow, the present invention will be described in detail.

In the present invention, the term "conductive" means that a surface resistance is $10^{11}$ Ω or less. The surface resistance is determined from the potential difference between electrodes when a constant current is flown between the electrodes.

In the present invention, the term "solubility" means that 0.1 g or more of a substance dissolves uniformly in 10 g (liquid temperature 25 °C) of simple water, water containing at least one of a base and a basic salt, water containing an acid, or a mixture of water and a water-soluble organic solvent.

Further, in the present specification, the term "water-soluble" means the solubility in water in relation to the aforementioned solubility.

In the present invention, the "terminal" of the "terminal hydrophobic group" means a site other than repeating units constituting a polymer.

<Conductive Composition>

The conductive composition of the present invention includes a conductive polymer (A), a water-soluble polymer (B) other than the conductive polymer (A), and a solvent (C), each of which is described below, wherein a peak area ratio is 0.44 or less, which is determined based on results of analysis performed using a high performance liquid chromatograph mass spectrometer with respect to a test solution obtained by extracting the water-soluble polymer (B) from the conductive composition with n-butanol, and calculated by formula (I):

$$\text{Area ratio} = Y/(X + Y) \qquad (I),$$

wherein X is a total peak area of an extracted ion chromatogram prepared with respect to ions derived from compounds having a molecular weight (M) of 600 or more from a total ion current chromatogram, Y is a total peak area of an extracted ion chromatogram prepared with respect to ions derived from compounds having a molecular weight (M) of less than 600 from the total ion current chromatogram.

When the area ratio calculated by the above formula (I) is 0.44 or less, the conductive polymer (A) is uniformly mixed in the conductive composition, and the filterability of the conductive composition is improved, and the filtration time in filtration of the conductive composition can be shortened. Also, when the conductive composition is microfiltered, the filter is less likely to be clogged, and the frequency of filter replacement is reduced.

The area ratio calculated by the formula (I) is preferably as small as possible, and is most preferably 0.

N-butanol is used for extraction of the water-soluble polymer (B). The use of n-butanol allows dissolution of the water-soluble polymer (B) without dissolving the conductive polymer (A) contained in the conductive composition to be extracted.

In place of n-butanol, it is also possible to use an organic solvent such as butyl acetate or methyl isobutyl ketone, which has an SP value of 6 to 15, and more preferably 7 to 13.

The conductive composition of the present invention may satisfy the following condition 1: a flow rate reduction of 40 % or less, which is a reduction in terms of percentage of a flow rate in 10th flow relative to a flow rate in 1st flow per unit time and unit membrane area when the conductive composition having a solid content of 0.5 % by mass is flowed through a nylon filter having a pore size of 40 nm under a constant pressure of 0.05 MPa using a pressure filtration device, wherein a total of 10 L of the composition is flowed by performing a flow of 1 L each of the composition 10 times.

Specifically, the flow rate reduction is determined by the following formula (II):

$$\text{Flow rate reduction} = \{(Z_1 - Z_{10})/Z_1\} \times 100 \qquad (II)$$

wherein $Z_1$ is an amount of liquid flow per unit time and unit membrane area in the 1st flow, and $Z_{10}$ is an amount of liquid flow per unit time and unit membrane area in the 10th flow.

$Z_1$ and $Z_{10}$ can be determined respectively by the following formulae (II-1) and (II-2).

$$Z_1 = 1/(\text{filtration time in the 1st flow} \times \text{filter membrane area}) \qquad (II\text{-}1)$$

$$Z_{10} = 1/(\text{filtration time in the 10th flow} \times \text{filter membrane area}) \qquad (II\text{-}2)$$

When the flow rate reduction is 40 % or less, the filtration time in the filtration of the conductive composition can be shortened. Also, when the conductive composition is microfiltered, the filter is less likely to be clogged, and the frequency of filter replacement is reduced.

The flow rate reduction is preferably as small as possible, and is most preferably 0%.

[Conductive Polymer (A)]

According to the present invention, the conductive polymer (A) is a water-soluble or water-dispersible conductive polymer and has at least one of a sulfonic acid group and a carboxy group.

Examples of the conductive polymer (A) include polypyrrole, polythiophene, polythiophene vinylene, polytellurophene, polyphenylene, polyphenylene vinylene, polyaniline, polyacene, polyacetylene and the like.

Among these, polypyrrole, polythiophene and polyaniline are preferable from the viewpoint of excellent conductivity.

Specific examples of monomers constituting polypyrrole include pyrrole, N-methylpyrrole, 3-methylpyrrole, 3-ethylpyrrole, 3-n-propylpyrrole, 3-butylpyrrole, 3-octylpyrrole, 3-decylpyrrole, 3-dodecylpyrrole, 3,4-dimethylpyrrole, 3,4-dibutylpyrrole, 3-carboxypyrrole, 3-methyl-4-carboxypyrrole, 3-methyl-4-carboxyethylpyrrole, 3-methyl- 4-carboxybutylpyrrole, 3-hydroxypyrrole, 3-methoxypyrrole, 3-ethoxypyrrole, 3-butoxypyrrole, 3-hexyloxypyrrole, 3-methyl-4-hexyloxypyrrole and the like.

Specific examples of monomers constituting polythiophene include thiophene, 3-methylthiophene, 3-ethylthiophene, 3-propylthiophene, 3-butylthiophene, 3-hexylthiophene, 3-heptylthiophene, 3-octylthiophene, 3-decylthiophene, 3-dodecylthiophene, 3-octadecylthiophene, 3-bromothiophene, 3-chlorothiophene, 3-iodothiophene, 3-cyanothiophene,

3-phenylthiophene, 3,4-dimethylthiophene, 3,4-dibutylthiophene, 3-hydroxythiophene, 3-methoxythiophene, 3-ethoxythiophene, 3-butoxythiophene, 3-hexyloxythiophene, 3-heptyloxythiophene, 3-octyloxythiophene, 3-decyloxythiophene, 3-dodecyloxythiophene, 3-octadecyloxythiophene, 3,4-dihydroxythiophene, 3,4-dimethoxythiophene, 3,4-diethoxythiophene, 3,4-dipropoxythiophene, 3,4-dibutoxythiophene, 3,4-dihexyloxythiophene, 3,4-diheptyloxythiophene, 3,4-dioctyloxythiophene, 3,4-didecyloxythiophene, 3,4-didodecyloxythiophene, 3,4-ethylenedioxythiophene, 3,4-propylenedioxythiophene, 3,4-butenedioxythiophene, 3-methyl-4-methoxythiophene, 3-methyl-4-ethoxythiophene, 3-carboxythiophene, 3-methyl-4-carboxythiophene, 3-methyl-4-carboxyethylthiophene, 3-methyl-4-carboxybutylthiophene, 6-(2,3-dihydro-thieno[3,4-b][1,4]dioxin-2-yl)hexane-1-sulfonic acid, 6-(2,3-dihydro-thieno[3,4-b][1,4]dioxin-2-yl)hexane-1-sulfonic acid sodium salt, 6-(2,3-dihydro-thieno[3,4-b][1,4]dioxin-2-yl)hexane-1-sulfonic acid lithium salt, 6-(2,3-dihydro-thieno[3,4-b][1,4]dioxin-2-yl)hexane-1-sulfonic acid potassium salt, 8-(2,3-dihydro-thieno[3,4-b][1,4]dioxin-2-yl)octane-1-sulfonic acid, 8-(2,3-dihydro-thieno[3,4-b][1,4]dioxin-2-yl)octane-1-sulfonic acid sodium salt, 8-(2,3-dihydrothieno [3,4-b] [1,4]dioxin-2-yl) octane-1-sulfonic acid potassium salt, 3-[(2,3-dihydrothieno[3,4-b]-[1,4]dioxin-2-yl)methoxy]-1-propanesulfonic acid sodium salt, 3-[(2,3-dihydrothieno[3,4-b]-[1,4]dioxin-2-yl)methoxy]-1-propanesulfonic acid potassium salt, 3-[(2,3-dihydrothieno[3,4-b]-[1,4]dioxin-2-yl)methoxy]-1-methyl-1-propanesulfonic acid sodium salt, 3-[(2,3-dihydrothieno[3,4-b]-[1,4]dioxin-2-yl)methoxy]-1-ethyl-1-propanesulfonic acid sodium salt, 3-[(2,3-dihydrothieno[3,4-b]-[1,4]dioxin-2-yl)methoxy]-1-propyl-1-propanesulfonic acid sodium salt, 3-[(2,3-dihydrothieno[3,4-b]-[1,4]dioxin-2-yl)methoxy]-1-butyl-1-propanesulfonic acid sodium salt, 3-[(2,3-dihydrothieno[3,4-b]-[1,4]dioxin-2-yl)methoxy]-1-pentyl-1-propanesulfonic acid sodium salt, 3-[(2,3-dihydrothieno[3,4-b]-[1,4]dioxin-2-yl)methoxy]-1-hexyl-1-propanesulfonic acid sodium salt, 3-[(2,3-dihydrothieno[3,4-b]-[1,4]dioxin-2-yl)methoxy]-1-isopropyl-1-propanesulfonic acid sodium salt, 3-[(2,3-dihydrothieno[3,4-b]-[1,4]dioxin-2-yl)methoxy]-1-isobutyl-1-propanesulfonic acid sodium salt, 3-[(2,3-dihydrothieno[3,4-b]-[1,4]dioxin-2-yl)methoxy]-1-isopentyl-1-propanesulfonic acid sodium salt, 3-[(2,3-dihydrothieno[3,4-b]-[1,4]dioxin-2-yl)methoxy]-1-fluoro-1-propanesulfonic acid sodium salt, 3-[(2,3-dihydrothieno [3,4-b]-[1,4]dioxin-2-yl)methoxy]-1-methyl-1-propane sulfonate potassium salt, 3-[(2,3-dihydrothieno[3,4-b]-[1,4]dioxy-2-yl)methoxy]-1-methyl-1-propanesulfonic acid salt, 3-[(2,3-dihydrothieno[3,4-b]-[1,4] dioxin-2-yl)methoxy]-1-methyl-1-propanesulfonic acid ammonium salt, 3-[(2,3-dihydrothieno[3,4-b]-[1,4]dioxin-2-yl)methoxy]-2-methyl-1-propanesulfonic acid sodium salt, 3-[(2,3-dihydrothieno[3,4-b]-[1,4]dioxin-2-yl)methoxy]-1-methyl-1-propanesulfonic acid triethylammonium salt, 4-[(2,3-dihydrothieno[3,4-b]-[1,4]dioxin-2-yl)methoxy]-1-butanesulfonic acid sodium salt, 4-[(2,3-dihydrothieno[3,4-b]-[1,4]dioxin-2-yl)methoxy]-1-butanesulfonic acid potassium salt, 4-[(2,3-dihydrothieno[3,4-b]-[1,4]dioxin-2-yl)methoxy]-1-methyl-1-butanesulfonic acid sodium salt, 4-[(2,3-dihydrothieno[3,4-b]-[1,4]dioxin-2-yl)methoxy]-1-methyl-1-butanesulfonic acid potassium salt, 4-[(2,3-dihydrothieno[3,4-b]-[1,4]dioxin-2-yl)methoxy]-1-fluoro-1-butanesulfonic acid sodium salt, and 4-[(2,3-dihydrothieno[3,4-b]-[1,4]dioxin-2-yl)methoxy]-1-fluoro-1-butanesulfonic acid potassium salt, and the like.

Other examples of the monomers constituting polythiophene include the monomers described in Japanese Unexamined Patent Application Publication Nos. 2016-188350, 2017-52886, 2014-65898 and 2017-101102.

Specific examples of monomers constituting polyaniline include aniline, 2-methylaniline, 3-isobutylaniline, 2-methoxyaniline, 2-ethoxyaniline, 2-anilinesulfonic acid, 3-anilinesulfonic acid and the like.

According to the present invention, the conductive polymer (A) has water solubility or water dispersibility. When the conductive polymer (A) has water solubility or water dispersibility, the ease in application of the conductive composition is enhanced, and a conductor having a uniform thickness can be easily obtained.

According to the present invention, the conductive polymer (A) has at least one of a sulfonic acid group and a carboxy group. When the conductive polymer (A) has at least one of a sulfonic acid group and a carboxy group, the water solubility can be enhanced. The conductive polymer having at least one of a sulfonic acid group and a carboxy group is not particularly limited as long as the polymer has at least one group selected from the group consisting of a sulfonic acid group and a carboxy group in its molecule and the effects of the present invention can be obtained, and the examples thereof preferable from the viewpoint of solubility include conductive polymers described in Japanese Patent Unexamined Publication Nos. Sho 61-197633, Sho 63-39916, Hei 1-301714, Hei 5-504153, Hei 5-503953, Hei 4-32848, Hei 4-328181, Hei 6-145386, Hei 6-56987, Hei 5-226238, Hei 5-178989, Hei 6-293828, Hei 7-118524, Hei 6-32845, Hei 6-87949, Hei 6-256516, Hei 7-41756, Hei 7-48436, Hei 4-268331, and 2014-65898.

Specific examples of the conductive polymer having at least one of a sulfonic acid group and a carboxy group include $\pi$-conjugated conductive polymers containing, as repeating units, at least one type of monomers selected from the group consisting of phenylene vinylene, vinylene, thienylene, pyrrolylene, phenylene, iminophenylene, isothianaphthene, furylene, and carbazolylene, each having its $\alpha$ position or $\beta$ position substituted with at least one group selected from the group consisting of a sulfonic acid group and a carboxy group.

When the $\pi$-conjugated conductive polymer contains at least one repeating unit selected from the group consisting of iminophenylene and carbazolylene, examples thereof include a conductive polymer having at least one group selected from the group consisting of a sulfonic acid group and a carboxy group on the nitrogen atoms of the repeating units, and a conductive polymer having an alkyl group (or an ether bond-containing alkyl group) substituted with at least one group selected from the group consisting of a sulfonic acid group and a carboxy group on the nitrogen atoms of the repeating units.

Among these, from the perspective of conductivity and solubility, it is preferable to use conductive polymers having at least one type of monomer unit (repeating unit) selected from the group consisting of thienylene, pyrrolylene, iminophenylene, phenylenevinylene, carbazolylene, and isothianaphthene, each having its β position substituted with at least one group selected from the group consisting of a sulfonic acid group and a carboxy group.

The conductive polymer (A) preferably has at least one type of monomer unit selected from the group consisting of monomer units represented by the following formulae (3) to (6) from the perspective of conductivity and solubility.

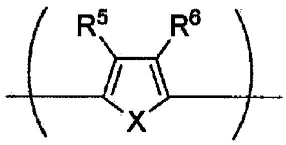

----- (3)

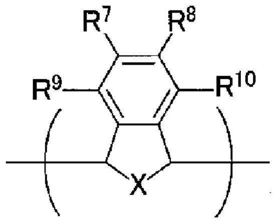

----- (4)

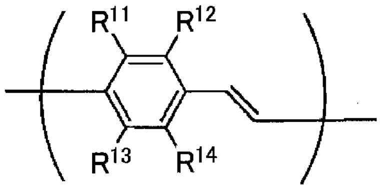

----- (5)

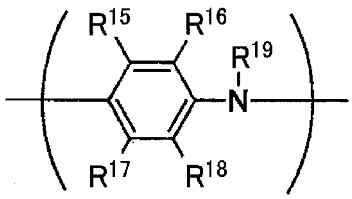

----- (6)

In the formulae (3) to (6), X represents a sulfur atom or a nitrogen atom, and each of $R^5$ to $R^{19}$ independently represents a hydrogen atom, a linear or branched alkyl group having 1 to 24 carbon atoms, a linear or branched alkoxy group having 1 to 24 carbon atoms, an acidic group, a hydroxy group, a nitro group, a halogen atom (-F, -Cl -Br or I), $-N(R^{20})_2$, $-NHCOR^{20}$, $-SR^{20}$, $-OCOR^{20}$, $-COOR^{20}$, $-COR^{20}$, -CHO or -CN. $R^{20}$ is preferably an alkyl group having 1 to 24 carbon atoms, an aryl group having 1 to 24 carbon atoms, or an aralkyl group having 1 to 24 carbon atoms.

However, at least one of $R^5$ to $R^6$ in the formula (3), at least one of $R^7$ to $R^{10}$ in the formula (4), at least one of $R^{11}$ to $R^{14}$ in the formula (5), and at least one of $R^{15}$ to $R^{19}$ in the formula (6) are each an acidic group or a salt thereof.

The "acidic group" means a sulfonic acid group (sulfo group) or a carboxylic acid group (carboxy group).

The sulfonic acid group may be present in an acid form ($-SO_3H$) or an ionic form ($-SO_3^-$). Further, the sulfonic acid group also encompasses a substituent having a sulfonic acid group ($-R^{21}SO_3H$).

On the other hand, the carboxylic acid group may be present in an acid form (-COOH) or an ionic form ($-COO^-$). Further, the carboxylic acid group also encompasses a substituent having a carboxylic acid group ($-R^{21}COOH$).

$R^{21}$ represents a linear or branched alkylene group having 1 to 24 carbon atoms, a linear or branched arylene group having 1 to 24 carbon atoms, or a linear or branched aralkylene group having 1 to 24 carbon atoms.

Examples of the salt of acidic group include alkali metal salts, alkaline earth metal salts, ammonium salts, and substituted ammonium salts of a sulfonic acid group or a carboxylic acid group.

Examples of the alkali metal salt include lithium sulfate, lithium carbonate, lithium hydroxide, sodium sulfate, sodium carbonate, sodium hydroxide, potassium sulfate, potassium carbonate, potassium hydroxide and derivatives having skeletons thereof.

Examples of the alkaline earth metal salt include magnesium salts, calcium salts and the like.

Examples of the substituted ammonium salt include aliphatic ammonium salts, saturated alicyclic ammonium salts, unsaturated alicyclic ammonium salts and the like.

Examples of the aliphatic ammonium salts include methyl ammonium, dimethyl ammonium, trimethyl ammonium, ethyl ammonium, diethyl ammonium, triethyl ammonium, methyl ethyl ammonium, diethyl methyl ammonium, dimethyl ethyl ammonium, propyl ammonium, dipropyl ammonium, isopropyl ammonium, diisopropyl ammonium, butyl ammonium, dibutyl ammonium, methyl propyl ammonium, ethyl propyl ammonium, methyl isopropyl ammonium, ethyl isopropyl ammonium, methyl butyl ammonium, ethyl butyl ammonium, tetramethyl ammonium, tetramethylol ammonium, tetra ethyl ammonium, tetra n-butyl ammonium, tetra sec-butyl ammonium, tetra t-butyl ammonium, and the like.

Examples of the saturated alicyclic ammonium salts include piperidinium, pyrrolidinium, morpholinium, piperazinium, and derivatives having skeletons thereof.

Examples of the unsaturated alicyclic ammonium salts include pyridinium, α-picolinium, β-picolinium, γ-picolinium, quinolinium, isoquinolinium, pyrrolinium, and derivatives having skeletons thereof.

The conductive polymer (A) preferably has a monomer unit represented by the above formula (6) since high conductivity can be achieved. Among the monomer units represented by the above formula (6), from the viewpoint of excellent solubility, especially preferred is a monomer unit represented by the following formula (1).

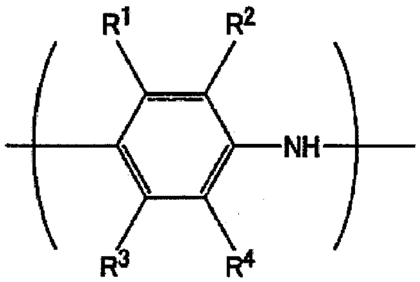

----- (1)

In the formula (1), each of $R^1$ to $R^4$ independently represents a hydrogen atom, a linear or branched alkyl group having 1 to 24 carbon atoms, a linear or branched alkoxy group having 1 to 24 carbon atoms, an acidic group, a hydroxy group, a nitro group or a halogen atom (-F, -Cl -Br or I), with the proviso that at least one of $R^1$ to $R^4$ is an acidic group or a salt thereof, and the acidic group is a sulfonic acid group or a carboxylic acid group.

As for the monomer unit represented by the above formula (1), it is preferable in terms of easy production that any one of $R^1$ to $R^4$ is a linear or branched alkoxy group having 1 to 4 carbon atoms, while another one of $R^1$ to $R^4$ is a sulfonic acid group, and the remainder is hydrogen.

In the conductive polymer (A), for achieving very good solubility, the number of acid group-bonded aromatic rings is preferably 50 % or more, more preferably 70 % or more, still more preferably 90 % or more, and most preferably 100 %, relative to the total number of aromatic rings present in the polymer.

The number of acid group-bonded aromatic rings relative to the total number of aromatic rings present in the polymer refers to a value calculated from the compounding ratio of monomers at the production of the conductive polymer (A).

Further, with respect to substituents on the aromatic rings of the monomer units in the conductive polymer (A), the substituents other than the sulfonic acid group and the carboxy group are preferably electron donating groups from the viewpoint of imparting reactivity to the monomers. Specifically, the substituents are preferably alkyl groups having 1 to 24 carbon atoms, alkoxy groups having 1 to 24 carbon atoms, halogen groups (-F, -Cl, -Br or I) and the like, and alkoxy groups having 1 to 24 carbon atoms are most preferable from the viewpoint of electron donation.

The conductive polymer (A) is preferably a compound having a structure represented by the following formula (7) since high conductivity and solubility can be achieved. Among the compounds having a structure represented by the formula (7), poly(2-sulfo-5-methoxy-1,4-iminophenylene) is particularly preferable.

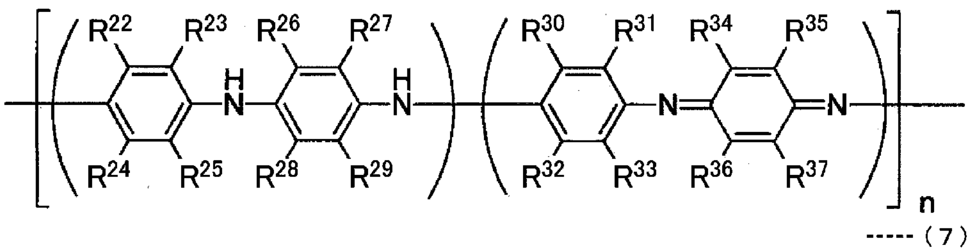

----- (7)

In the formula (7), each of $R^{22}$ to $R^{37}$ independently represents a hydrogen atom, a linear or branched alkyl

group having 1 to 4 carbon atoms, a linear or branched alkoxy group having 1 to 4 carbon atoms, an acidic group, a hydroxy group, a nitro group or a halogen atom (-F, -Cl -Br or I). At least one of $R^{22}$ to $R^{37}$ is an acidic group or a salt thereof. Further, n represents a polymerization degree. In the present invention, n is preferably an integer of 5 to 2500.

It is desirable that at least a part of the acidic groups contained in the conductive polymer (A) is in a free acid form from the viewpoint of conductivity improvement.

Other than those described above as the conductive polymer (A), for example, it is possible to use, as the conductive polymer having a sulfonic acid group, a conductive polymer having at least one type of monomer unit selected from the group consisting of monomer units represented by the following formulae (8) and (9).

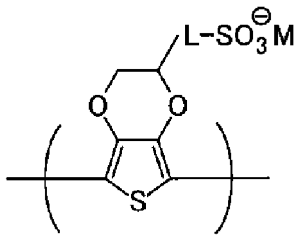

----- (8)

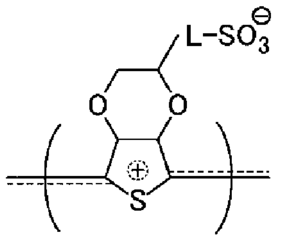

----- (9)

In the formulae (8) and (9), L is represented by $-(CH_2)_p-$ or the following formula (10), M represents a hydrogen ion, an alkali metal ion, an alkaline earth metal ion, a conjugate acid of an amine compound, or a quaternary ammonium cation. In these formulae, p is an integer of 6 to 12.

The term "conjugate acid of an amine compound" indicates an amine compound turned into a cationic species by addition of a hydrone ($H^+$). Specific examples include an amine compound represented by $N(R^{38})_3$ having sp3 hybrid orbitals (the conjugate acid being represented by $[NH(R^{38})_3]^+$), and a pyridine compound or an imidazole compound having sp2 hybrid orbitals. $R^{38}$ is a hydrogen atom or an alkyl group having 1 to 6 carbon atoms.

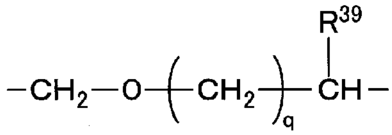

----- (10)

In the formula (10), $R^{39}$ represents a hydrogen atom, a linear or branched alkyl group having 1 to 6 carbon atoms, or a halogen atom (-F, -Cl -Br or I). In this formula, q represents an integer of 1 to 6.

The monomer unit represented by the formula (9) shows a doped state of the monomer unit represented by the general formula (8).

Dopants that cause an insulator-metal transition by doping include an acceptor and a donor. An acceptor approaches a polymer chain of the conductive polymer (A) and takes $\pi$ electrons away from the conjugated system of the main chain by doping. As a result, positive charges (holes) are injected onto the main chain; therefore, the acceptor is also referred to as a p-type dopant. On the other hand, the donor is also referred to as a n-type dopant because it supplies electrons to the conjugated system of the main chain, and these electrons move in the conjugated system of the main chain.

From the perspective of conductivity, solubility and film formability, the weight average molecular weight of the conductive polymer (A) is preferably 1,000 to 1,000,000, more preferably 1,500 to 800,000, still more preferably 2,000 to 500,000, and particularly preferably 2,000 to 100,000, in terms of sodium polystyrene sulfonate as determined by gel permeation chromatography (hereinafter referred to as "GPC").

When the weight average molecular weight of the conductive polymer (A) is less than 1,000, good solubility may be achieved, but the conductivity and the film formability may be insufficient. On the other hand, when the weight average molecular weight is larger than 1,000,000, good conductivity may be achieved, but the solubility may be insufficient.

The term "film formability" refers to an ability to form a uniform film without cissing etc., which can be evaluated by a method such as spin coating on glass.

As for the method for producing the conductive polymer (A), there is no particular limitation and any known method can be employed as long as the desired effects of the present invention are available.

Specific examples of the method include a method of polymerizing polymerizable monomers capable of forming any of the above monomer units by various synthesis methods such as a chemical oxidation method, an electrolytic oxidation method and the like. As such method, for example, the synthesis methods proposed by the present inventors in Japanese Unexamined Patent Application Publication Nos. Hei 7-196791 and Hei 7-324132 can be adopted.

In the conductive composition of the present invention, the amount of the conductive polymer (A) is preferably 0.01 to 50 % by mass, and more preferably 0.05 to 20 % by mass, based on the total mass (100 % by mass) of the conductive composition.

[Water-soluble Polymer (B)]

The water-soluble polymer (B) is a polymer other than the conductive polymer (A). According to the present invention, the water-soluble polymer (B) is a homopolymer of a vinyl monomer having an amide bond, or a compound having a main chain structure formed of a copolymer of a vinyl monomer having an amide bond and a vinyl monomer having no amide bond, and has a terminal hydrophobic group of 4 or more carbon atoms in its molecule.

The water-soluble polymer (B) preferably satisfies the following condition 2: an in-liquid particle number of not more than 5000 particles/ml of liquid as measured with respect to particles having a size of 0.5 to 1 μm in an aqueous solution containing 0.2 % by mass of the water-soluble polymer (B) and 99.8 % by mass of ultrapure water by a liquid particle counter.

The in-liquid particles of 0.5 to 1 μm are particles having a particle diameter of 0.5 to 1 μm and contained in a liquid, which correspond to foreign matter. The proportion of foreign matter in the conductive composition increases as the number of in-liquid particles increases, resulting in longer filtration time in microfiltration of the conductive composition. In addition, the filter is likely to be clogged, and the frequency of filter replacement increases. When the number of in-liquid particles is 5,000 particles/ml or less, the foreign matter in the conductive composition is reduced, so that the filterability is further improved, and the resulting conductive composition requires less filtration time. In addition, when the conductive composition is microfiltered, the filter is less likely to be clogged, and the frequency of filter replacement is further reduced.

The number of in-liquid particles is preferably as small as possible, and 0 particle/ml is most preferable.

The purification method of particle removal for the water-soluble polymer (B) to satisfy the condition 2 is not particularly limited, the examples of which include contacting with an adsorbent such as a hydrophobic substance (e.g., an octadecyl group-modified silica or an activated carbon), washing with a solvent, and filtration.

Incidentally, the aforementioned in-liquid particles of 0.5 to 1 μm are presumed to be compounds having a molecular weight of less than 600 (hereinafter also referred to as "compound (b)") among the compounds belonging to the water-soluble polymer (B). That is, the compound (b) is considered to be one of the substances that cause prolongation of the filtration of the conductive composition, and the proportion of the compound (b) in the conductive composition is preferably as low as possible. The proportion of the compound (b) is determined from the value of peak area ascribed to the compound (b), which is measured using a high performance liquid chromatograph-mass spectrometer. There is a correlation between the area ratio calculated by the formula (I) and the number of in-liquid particles, and when the area ratio is 0.44 or less, the number of in-liquid particles tends to be 5000 particles/ml or less.

The water-soluble polymer (B) has a nitrogen-containing functional group and a terminal hydrophobic group in its molecule since such a water-soluble polymer (B) is likely to exhibit surface activity and can easily suppress the influence on the resist.

As the nitrogen-containing functional group, an amide group is used from the viewpoint of solubility.

The carbon number of the terminal hydrophobic group is 4 or more, and preferably 8 or more. The carbon number of the terminal hydrophobic group is preferably 100 or less.

The terminal hydrophobic group is preferably one having an alkyl chain, an aralkyl chain or an aryl chain in the hydrophobic group. Specifically, from the viewpoint of solubility and surface activity, the terminal hydrophobic group preferably contains at least one selected from the group consisting of an alkyl chain having 4 to 100 carbon atoms, an aralkyl chain having 4 to 100 carbon atoms, and an aryl chain having 4 to 100 carbon atoms. The number of carbon atoms of each of these alkyl chain, aralkyl chain and aryl chain is preferably 4 to 70, and more preferably 8 to 30.

Specific examples of such terminal hydrophobic groups include alkyl groups, aralkyl groups, aryl groups, alkoxy groups, aralkyloxy groups, aryloxy groups, alkylthio groups, aralkylthio groups, arylthio groups, primary or secondary alkylamino groups, aralkylamino groups, and arylamino groups. Among these, alkylthio groups, aralkylthio groups, and arylthio groups are preferable, and alkylthio groups are particularly preferable from the viewpoint of solubility and surface

activity.

The water-soluble polymer (B) is preferably a homopolymer of a vinyl monomer having an amide bond, or a compound having a main chain structure formed of a copolymer of a vinyl monomer having an amide bond and a vinyl monomer having no amide bond (another vinyl monomer), and having a hydrophobic group at a site other than repeating units constituting the polymer.

Examples of the vinyl monomer having an amide bond include acrylamide and derivatives thereof, N-vinyl lactam and the like. Specific examples thereof include acrylamide, N,N-dimethyl acrylamide, N-isopropyl acrylamide, N,N-diethyl acrylamide, N,N-dimethylaminopropyl acrylamide, t-butyl acrylamide, diacetone acrylamide, N,N'-methylenebisacrylamide, N-vinyl-N-methyl acrylamide, N-vinyl pyrrolidone, N-vinyl caprolactam and the like. Among these, from the viewpoint of solubility, acrylamide, N-vinylpyrrolidone, N-vinylcaprolactam and the like are particularly preferable.

The method for introducing the terminal hydrophobic group into the water-soluble polymer (B) is not particularly limited as long as the effects of the present invention are obtained, but a method of introducing the terminal hydrophobic group by selecting a chain transfer agent for the vinyl polymerization is simple and preferred.

For example, the water-soluble polymer (B) having a nitrogen-containing functional group and a terminal hydrophobic group having 4 or more carbon atoms in its molecule can be produced by polymerizing a vinyl monomer having an amide bond and, if necessary, another vinyl monomer, in the presence of a polymerization initiator and a chain transfer agent having 4 or more carbon atoms.

The chain transfer agent is not particularly limited as long as the above-mentioned terminal hydrophobic group can be introduced and the effects of the present invention can be obtained, but it is preferable to use thiol, disulfide, thioether etc., with which an alkylthio group, an aralkylthio group, an arylthio group etc. which are preferable terminal hydrophobic groups can be easily introduced.

The number of repeating units of the main chain structure moiety of the water-soluble polymer (B), that is, the polymerization degree of the above-mentioned vinyl monomer having an amide bond, is preferably 2 to 100,000, more preferably 2 to 1000, and particularly preferably 3 to 200, from the perspective of the solubility of the water-soluble polymer (B).

From the viewpoint of surface activity, the ratio of a molecular weight of the main chain structure moiety (hereinafter also referred to as "molecular weight of the water soluble portion") relative to a molecular weight of the terminal hydrophobic moiety (hereinafter also referred to as "molecular weight of hydrophobic moiety"), i.e., (molecular weight of water-soluble moiety)/(molecular weight of hydrophobic moiety), is preferably 1 to 1,500, and more preferably 3 to 1,000. The "molecular weight of water-soluble moiety" and "molecular weight of hydrophobic moiety" can be calculated from the weight average molecular weight of the obtained water-soluble polymer (B), and the compounding ratio of the monomer for constituting the main chain structure moiety and the chain transfer agent for constituting the terminal hydrophobic moiety.

The weight average molecular weight of the water-soluble polymer (B) having a nitrogen-containing functional group and a terminal hydrophobic group in its molecule is preferably 100 to 1,000,000, more preferably 100 to 100,000, still more preferably 600 or more and less than 2,000, and particularly preferably 600 to 1,800, in terms of polyethylene glycol in GPC. When the weight average molecular weight of the water-soluble polymer (B) is 100 or more, the ease in application of the conductive composition can be more easily achieved. On the other hand, when the weight average molecular weight of the water-soluble polymer (B) is 1,000,000 or less, the water solubility is enhanced. In particular, when the weight average molecular weight of the water-soluble polymer (B) is 600 or more and less than 2,000, an excellent balance is achieved between the practical solubility thereof in water and the ease in application of the conductive composition.

The water-soluble polymer (B) is preferably a compound represented by the following formula (2) from the viewpoint of solubility and the like.

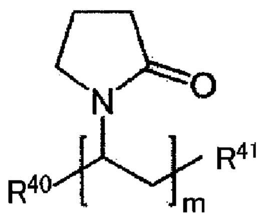

----- (2)

In the formula (2), each of $R^{40}$ and $R^{41}$ independently represents an alkylthio group, an aralkylthio group, an arylthio group or a hydrocarbon group, with the proviso that at least one of $R^{40}$ and $R^{41}$ is an alkylthio group, an aralkylthio group or an arylthio group; and m represents an integer of 2 to 100000.

Examples of the hydrocarbon group include a linear or branched alkyl group having 1 to 20 carbon atoms, a linear or branched alkenyl group having 1 to 20 carbon atoms, and a linear or branched alkynyl group having 1 to 20

carbon atoms.

The amount of the water-soluble polymer (B) is preferably 5 to 200 parts by mass, and more preferably 10 to 100 parts by mass, with respect to 100 parts by mass of the conductive polymer (A). By combining the water-soluble polymer (B) with its amount adjusted as mentioned above with the above-mentioned conductive polymer (A), it becomes possible to obtain a composition which is easy to apply and can form a coating with less influence on a laminated material such as a resist applied to a substrate.

In the conductive composition of the present invention, the sum of the amounts of the conductive polymer (A) and the water-soluble polymer (B) is preferably 0.01 parts by mass or more and less than 5 parts by mass, relative to 100 parts by mass of the solvent (C) described later. The sum is more preferably 0.1 parts by mass or more and 3 parts by mass or less from the viewpoint of the conductivity and surface smoothness after film formation.

[Solvent (C)]

The solvent (C) is can dissolve the conductive polymer (A) and the water-soluble polymer (B) and the effects of the present invention can be obtained. According to the present invention water or a mixed solvent of water and an organic solvent is used as the solvent (C).

Examples of the organic solvent include alcohols such as methanol, ethanol, isopropyl alcohol, propyl alcohol and butanol; ketones such as acetone and ethyl isobutyl ketone; ethylene glycols such as ethylene glycol and ethylene glycol methyl ether; propylene glycols such as propylene glycol, propylene glycol methyl ether, propylene glycol ethyl ether, propylene glycol butyl ether and propylene glycol propyl ether; amides such as dimethylformamide and dimethylacetamide; and pyrrolidones such as N-methylpyrrolidone and N-ethylpyrrolidone.

When a mixed solvent of water and an organic solvent is used as the solvent (C), the mass ratio of water to an organic solvent (water/organic solvent) is preferably 1/100 to 100/1, and more preferably 2/100 to 100/2.

[Polymeric Compound (D)]

The conductive composition of the present invention may contain a polymer compound (D) for the purpose of improving the coating strength and the surface smoothness.

Specific examples of the polymer compound (D) include polyvinyl alcohol derivatives such as polyvinyl formal and polyvinyl butyral, polyacrylamides such as polyacrylamide, poly(N-t-butyl acrylamide) and polyacrylamide methyl propane sulfonate, polyvinyl pyrrolidones, polyacrylic acids, water-soluble alkyd resins, water-soluble melamine resins, water-soluble urea resins, water-soluble phenol resins, water-soluble epoxy resins, water-soluble polybutadiene resins, water-soluble acrylic resins, water-soluble urethane resins, water-soluble acrylic styrene copolymer resins, water-soluble vinyl acetate acrylic copolymer resins, and water-soluble polyester resins, water-soluble styrene maleic acid copolymer resins, water-soluble fluoro resins, and copolymers thereof.

[Basic Compound (E)]

Furthermore, a basic compound (E) may be added to the conductive composition of the present invention as required. When the conductive polymer (A) contains an acidic group, the basic compound (E) serves to generate a salt with the acidic group to neutralize the acidic group. By neutralization, the influence on the resist can be suppressed.

The basic compound (E) is not particularly limited, but when the conductive polymer (A) has an acidic group, the basic compound (E) preferably includes at least one selected from the group consisting of a quaternary ammonium salt (e-1) and a basic compound (e-2) which are described below, because the formation of a salt with the acidic group is facilitated, thereby stabilizing the acidic group to achieve excellent effect of preventing acidic substances derived from the antistatic film from affecting the resist pattern.

Quaternary ammonium salt (e-1): a quaternary ammonium compound in which at least one of the four substituents bonded to the nitrogen atom is a hydrocarbon group having 3 or more carbon atoms.

Basic compound (e-2): a basic compound having one or more nitrogen atoms.

In the quaternary ammonium compound (e-1), the nitrogen atom to which the four substituents are bonded is a nitrogen atom of the quaternary ammonium ion.

Examples of the hydrocarbon group bonded to the nitrogen atom of the quaternary ammonium ion in the compound (e-1) include an alkyl group, an aralkyl group and an aryl group.

Examples of the quaternary ammonium compound (e-1) include tetrapropylammonium hydroxide, tetrabutylammonium hydroxide, tetrapentylammonium hydroxide, tetrahexylammonium hydroxide, benzyltrimethylammonium hydroxide and the like.

Examples of the basic compound (e-2) include ammonia, pyridine, triethylamine, 1,5-diazabicyclo[4.3.0]-5-nonene (DBN), 1,8-diazabicyclo [5.4.0]-7-undecene (DBU), and derivatives thereof.

One of these basic compounds may be used alone, or two or more of them may be used in the form of a mixture thereof with an appropriate blending ratio.

As the basic compound (E), basic compounds other than the quaternary ammonium compound (e-1) and the basic compound (e-2) can also be mixed.

[Optional Component]

Further, the conductive composition of the present invention may optionally contain any of various additives, such as a pigment, an antifoaming agent, an ultraviolet light absorber, an antioxidant, a heat resistance improver, a leveling agent, an antidripping agent, matting agents and preservatives.

[Production method]

The conductive composition of each of the present invention can be obtained, for example, by mixing the conductive polymer (A), the water-soluble polymer (B), the solvent (C), and, if necessary, at least one of the compound (D), the basic compound (E) and the optional components.

When using a synthetic product as the water-soluble polymer (B), e.g., a product obtained by polymerizing a vinyl monomer having an amide bond in the presence of a polymerization initiator and a chain transfer agent having 4 or more carbon atoms, the condition 2 may not be met. In such a case, the mixing of the components is preferably preceded by purification of the water-soluble polymer (B) by at least one process selected from the group consisting of the processes (i) to (iii) described below. Purification of the water-soluble polymer (B) is preferably performed by at least one of the processes (i) and (ii). That is, the method for producing the conductive composition according to the present invention includes a step of purifying the water-soluble polymer (B) by at least one of the processes (i) and (ii).

By purifying the water-soluble polymer (B), the water-soluble polymer (B) satisfying the condition 2 can be easily obtained, and the area ratio calculated by the formula (I) tends to be 0.44 or less. Furthermore, by purifying the water-soluble polymer (B), the resulting conductive composition is more likely to satisfy the condition 1. In particular, by performing the process (i) and the process (ii), it becomes easy to obtain a conductive composition having the area ratio of 0.44 or less calculated by the formula (I) and satisfying the condition 1.

(i): a process of washing a solution containing the water-soluble polymer (B) with a solvent.
(ii): a process of filtering a solution containing the water-soluble polymer (B) through a filter.
(iii) a process of contacting a solution containing the water-soluble polymer (B) with an adsorbent.

Examples of the solvent used in the process (i) include hydrocarbon solvents such as hexane, heptane and octane, and ether solvents such as ethyl ether and propyl ether.

Examples of the material of the filter used in the process (ii) include polypropylene, polyethylene, polytetrafluoroethylene, surface-modified polyethylene and the like.

Examples of the adsorbent used in the process (iii) include hydrophobic substances such as octadecyl group-modified silica and activated carbon, etc.

Further, after mixing the components, it is preferable to filter the resulting mixture. The filtration makes it easier to obtain a conductive composition having the area ratio of 0.44 or less calculated by the formula (I) and a conductive composition satisfying the condition 1.

[Effect of the invention]

The conductive composition of the present invention as described above includes the conductive polymer (A), the water-soluble polymer (B), and the solvent (C), and has an area ratio of 0.44 or less calculated by the formula (I), whereby the foreign matter content is reduced in the conductive composition of the present invention. Therefore, the conductive composition of the present invention requires less time for filtration.

Further, the conductive composition of the present invention includes the conductive polymer (A), the water-soluble polymer (B), and the solvent (C), and satisfies the condition 1, whereby the conductive composition requires less time for filtration.

Therefore, when the conductive composition of the present invention is microfiltered, the filter is less likely to be clogged, and the frequency of filter replacement is reduced. Especially, when the water-soluble polymer (B) satisfies the condition 2, the filtration time is shortened even further.

The conductive composition of the present invention can be used as an antistatic agent applicable even to the next-generation process for semiconductor devices, and can shorten filtration time in microfiltration and reduce frequency of filter replacement and clogging.

In addition, when the water-soluble polymer (B) has a nitrogen-containing functional group and a terminal hydrophobic group in its molecule, surface activation performance can be achieved by the main chain structure moiety (water-soluble moiety) and the terminal hydrophobic group (hydrophobic moiety). Such a water-soluble polymer (B) does not contain an acid or a base, and is less likely to generate by-products by hydrolysis; therefore, the water-soluble polymer (B) can improve the ease in application of the composition without adversely affecting a substrate or a laminated material such as a resist applied to a substrate.

Furthermore, when the terminal hydrophobic group of the water-soluble polymer (B) has 4 or more carbon atoms, preferably 8 or more carbon atoms, entanglement of carbon chains can be increased in the coating, thereby enabling the formation of a strong coating.

As a result, when the conductive composition is applied to a resist layer to form a coating, the resulting coating can prevent the low molecular weight component from migrating to an interface with the resist and dissolving the surface.

Therefore, when the conductive composition of the present invention contains the water-soluble polymer (B) having a nitrogen-containing functional group and a terminal hydrophobic group in its molecule, the conductive composition excels in ease in application, and can form a coating that exhibits conductivity and has less influence on a laminated material such as a resist applied to a substrate.

The conductive composition of the present invention can form a conductor having an insoluble or peelable-soluble coating (conductive polymer film) when heated after being formed into a conductor.

This is advantageous in that the conductor is applicable either as a permanent antistatic film or a temporary antistatic film used during the process.

In still another aspect of the conductive composition of the present invention,

the conductive composition includes the conductive polymer (A), the water-soluble polymer (B) and the solvent (C) as defined above,
wherein the conductive polymer (A) has a monomer unit represented by the above formula (1),
the water-soluble polymer (B) satisfies the above condition 2, and
the area ratio calculated by the above formula (I) is 0.44 or less.

In still another aspect of the conductive composition of the present invention,

the conductive composition includes the conductive polymer (A), the water-soluble polymer (B) and the solvent (C) as defined above,
wherein the conductive polymer (A) has a monomer unit represented by the above formula (1),
the water-soluble polymer (B) satisfies the above condition 2 and is a compound represented by the above formula (2), and
the area ratio calculated by the above formula (I) is 0.44 or less.

In still another aspect of the conductive composition of the present invention,

the conductive composition includes the conductive polymer (A), the water-soluble polymer (B) and the solvent (C) as defined above,
wherein the conductive polymer (A) has a monomer unit represented by the above formula (1),
the water-soluble polymer (B) satisfies the above condition 2,
the amount of the conductive polymer (A) is 0.01 to 50 % by mass based on the total mass of the conductive composition,
the amount of the water-soluble polymer (B) is 5 to 200 parts by mass with respect to 100 parts by mass of the conductive polymer (A),
the sum of the amount of the conductive polymer (A) and the amount of the water-soluble polymer (B) is 0.01 parts by mass or more and less than 5 parts by mass with respect to 100 parts by mass of the solvent (C), and
the area ratio calculated by the above formula (I) is 0.44 or less.

In still another aspect of the conductive composition of the present invention,

the conductive composition includes the conductive polymer (A), the water-soluble polymer (B) and the solvent (C) as defined above,
wherein the conductive polymer (A) has a monomer unit represented by the above formula (1),
the water-soluble polymer (B) satisfies the above condition 2 and is a compound represented by the above formula (2),
the amount of the conductive polymer (A) is 0.01 to 50 % by mass based on the total mass of the conductive composition,

the amount of the water-soluble polymer (B) is 5 to 200 parts by mass with respect to 100 parts by mass of the conductive polymer (A),
the sum of the amount of the conductive polymer (A) and the amount of the water-soluble polymer (B) is 0.01 parts by mass or more and less than 5 parts by mass with respect to 100 parts by mass of the solvent (C), and
the area ratio calculated by the above formula (I) is 0.44 or less,

As another aspect of the method for producing the conductive composition of the present invention, the following method can be mentioned:
a method for producing the conductive composition, including a step of purifying the water-soluble polymer (B) by at least one process selected from the group consisting of the above-mentioned processes (i) to (iii).
As still another aspect of the method for producing the conductive composition of the present invention, the following method can be mentioned:

a method for producing the conductive composition, including a step of purifying the water-soluble polymer (B) by the above-mentioned processes (i) and (ii),
wherein the water-soluble polymer (B) is obtained by polymerizing a vinyl monomer having an amide bond in the presence of a polymerization initiator and a chain transfer agent having 4 or more carbon atoms; and
and wherein the step of purifying the water-soluble polymer (B) precedes the mixing of the components of the conductive composition.

As still another aspect of the method for producing the conductive composition of the present invention, the following method can be mentioned:
a method for producing the conductive composition, including a step of purifying the water-soluble polymer (B) by performing the above-mentioned processes (i) and (ii) in this order.

<Conductor>

The conductor includes a substrate and a coating formed by applying the conductive composition of the present invention on at least one surface of the substrate.
The method of applying the conductive composition to the substrate is not particularly limited as long as the effects of the present invention are obtained. Examples of the method include spin coating, spray coating, dip coating, roll coating, gravure coating, reverse coating, roll brush method, air knife coating and curtain coating.
The substrate is not particularly limited as long as the effects of the present invention are obtained. Examples of the substrate include molded articles of various polymers such as polyester resins (e.g., polyethylene terephthalate and polybutylene terephthalate), polyolefin resins represented by polyethylene and polypropylene, vinyl chloride, nylon, polystyrene, polycarbonate, epoxy resins, fluoro resins, polysulfone, polyimide, polyurethane, phenol resins, silicon resins, and synthetic papers; and films, papers, iron, glass, quartz glass, various wafers, aluminum, copper, zinc, nickel, stainless steel and the like; and products obtainable by coating surfaces of these substrates with various coating materials, photosensitive resins, resists and the like.
The application of the conductive composition to the substrate may be performed before or during the process of producing the substrate, such as uniaxial stretching, biaxial stretching, molding, or embossing, or may be performed on the produced substrate after the aforementioned process.
Further, since the conductive composition of the present invention is excellent in ease in application, the conductive composition can be used to form a coating by overcoating the substrate which has already been coated with various coating materials or photosensitive materials.
As for the method for producing the conductor of the present invention, the conductor can be produced by a method in which the conductive composition of the present invention is applied to at least one surface of a substrate and dried to form a coating, and allowed to stand for 1 minute to 60 minutes at normal temperature (25 °C) or subjected to heat treatment.
The heating temperature for the heat treatment is preferably in the range of 40 °C to 250 °C, and more preferably in the range of 60 °C to 200°C, from the viewpoint of conductivity. Further, the time for heat treatment is preferably within 1 hour, and more preferably within 30 minutes, from the viewpoint of stability.

EXAMPLES

Hereinbelow, the present invention will be specifically described in more detail by way of Examples.
The various measurements and evaluations were performed in the Examples and Comparative Examples by respective methods as described below.

<Measurement of Molecular Weight>

A 0.1 % by mass aqueous solution of the water-soluble polymer (B) was filtered through a 0.45 μm membrane filter to prepare a sample. The GPC analysis of the sample was performed under the conditions described below to measure the weight average molecular weight of the water-soluble polymer (B).

(GPC Measurement Conditions)

- Measuring apparatus: TOSOH GPC-8020 (manufactured by Tosoh Corporation)
- Eluent: 0.2 M-$NaNO_3$-DIW/acetonitrile = 80/20 (v/v)
- Column temperature: 30 °C
- Calibration curve: prepared using EasiVial™ polyethylene glycol/oxide (manufactured by PolymerLab)

<Measurement of In-liquid Particles>

Using a liquid particle counter, the amount of in-liquid particles in the water-soluble polymer (B) was measured. As the in-liquid particle counter, KS-42C manufactured by RION Co., Ltd. was used. The measurement was performed with a sample flow rate of 10 ml/min. The sample was prepared such that the amount of the water-soluble polymer (B) was 0.2 % by mass and the amount of the ultrapure water was 99.8 % by mass, and the number of in-liquid particles in 0.5 to 1 μm of the sample was measured at 23 °C.

<High-performance Liquid Chromatograph Mass Spectrometry (LC-MS)>

1 ml of n-butanol was added to 2 ml of the conductive composition, and the resulting mixture was subjected to shake extraction to separate the mixture into two layers. From the resulting, the supernatant n-butanol layer was separated. The separated n-butanol layer was used as a test solution, and the measurement was performed under the following LC-MS measurement conditions.

(LC-MS measurement conditions)

- Device: mass spectrometer of LC/1200 series/6220A time-of-flight mass spectrometer (manufactured by Agilent Technologies)
- Column: CAPCELL PAK C18 AQ (3 μm, 2.0 × 250 mm) (manufactured by Shiseido Company, Limited)
- Eluent A: water containing 0.1 % formic acid
- Eluent B: acetonitrile containing 0.1 % formic acid/isopropyl alcohol = 1/1 (v/v)
- Gradient elution conditions: linear gradient 0 minutes (eluent A/eluent B = 98/2) - 55 minutes (eluent A/eluent B = 0/100) - 75 minutes (eluent A/eluent B = 0/100)
- Flow rate: 0.2 ml/min
- Measurement temperature: 40 °C
- Sample injection volume: 5 μl

(Mass Spectrometry)

- Ionization method: ESI
- Polarity: Positive ion
- Capillary voltage: 3500 V
- Fragmenter voltage: 150 V
- Nebulizer pressure: 50 psig
- Drying gas temperature: 350 °C
- Drying gas flow rate: 10 L/min

From the total ion current chromatogram, an extracted ion chromatogram was prepared with respect to ions

derived from the respective compounds, and respective peak areas were determined. From the total peak area (X) ascribed to compounds having a molecular weight (M) of 600 or more, and the total peak area (Y) ascribed to compounds having a molecular weight (M) of less than 600, the peak area ratio (Y/(X + Y)) was calculated.

<Evaluation of filtration time>

Using a pressure filtration apparatus, 10 L of the conductive composition was passed through the filter under a constant pressure of 0.05 MPa by performing a filtration of 1 L each of the conductive composition ten times, and the filtration time per 1 L was measured. As the filter, a nylon filter having a pore size of 40 nm and a membrane area of 2200 $cm^2$ was used. Evaluation was performed based on the following criteria, comparing the filtration times in the first filtration and the last (10th) filtration.

◦: Difference in the filtration time between the first 1 L and the last 1 L is less than 10 seconds
×: Difference in the filtration time between the first 1 L and the last 1 L is 10 seconds or more

[Production Example 1]

<Conductive Polymer (A-1)>

5 mol of 2-aminoanisole-4-sulfonic acid was dissolved in 3000 mL of a 2 mol/L aqueous acetonitrile solution of pyridine (water/acetonitrile = 5:5) at 25 °C to obtain a monomer solution. Separately, 5 mol of ammonium peroxodisulfate was dissolved in 4 L of an aqueous acetonitrile solution (water/acetonitrile = 5:5) to obtain an oxidant solution. Then, the monomer solution was added dropwise to the oxidant solution while cooling the oxidant solution to 0 °C. After completion of the dropwise addition, the resulting mixture was further stirred at 25 °C for 12 hours to obtain a reaction mixture containing a conductive polymer. Thereafter, the conductive polymer was separated from the reaction mixture by a centrifugal filter. The obtained conductive polymer was washed with methanol and then dried to obtain 500 g of a powdery conductive polymer (A-1).

[Production Example 2]

<Conductive polymer (A-2)>

In a nitrogen atmosphere, 0.505 g (1.52 mmol) of sodium 3-[(2,3-dihydrothieno[3,4-b]-[1,4]dioxin-2-yl)methoxy]-2-methyl-1-propanesulfonate and 7.5 mL of water were charged into a 50 mL Schlenk flask, followed by addition of 0.153 g (0.93 mmol) of anhydrous iron (III) chloride and stirring at room temperature for 20 minutes. Then, a mixed solution of 0.724 g (3.05 mmol) of sodium persulfate and 5 ml of water was added dropwise by a syringe. After being stirred at room temperature for 3 hours, the resulting reaction solution was added dropwise to 100 mL of acetone to precipitate a black polymer. The polymer was filtered and vacuum dried to obtain 0.88 g of sodium 3-[(2,3-dihydrothieno[3,4-b]-[1,4]dioxin-2-yl)methoxy]-1-methyl-1-propanesulfonate. Then, to an aqueous solution prepared by adding water to the obtained polymer to adjust its concentration to 1 % by mass, 9.2 g of a cation exchange resin (Lewatit MonoPlus S100(H type)) was added, and the resulting mixture was stirred at room temperature for 13 hours. The cation exchange resin was separated by filtration to obtain a deep ultramarine blue aqueous solution. The obtained deep ultramarine blue aqueous solution was dialyzed using a dialysis membrane (Spectra/Por, molecular weight cut off (MWCO) = 3500) to remove inorganic salts. Further, the resulting ultramarine blue aqueous solution was concentrated to 6.3 g and reprecipitated in 120 mL of acetone to obtain 353 mg of a black powdery conductive polymer (A-2).

[Production Example 3]

<Water-soluble polymer (B-1, B-2)>

55 g of N-vinylpyrrolidone, 3 g of azobisisobutyronitrile as a polymerization initiator, 1 g of n-dodecyl mercaptan as a chain transfer agent were dropwise added to 100 g of isopropyl alcohol which had been heated to an internal temperature of 80 °C in advance, while maintaining the internal temperature at 80 °C, thereby performing polymerization. After completion of the dropwise addition, aging was carried out for further 2 hours at an internal temperature of 80 °C, and the resulting was allowed to cool and subjected to vacuum concentration, thereby obtaining an isopropyl alcohol solution of the water-soluble polymer (B-1) in which each of $R^{40}$ and $R^{41}$ in the formula (2) is an alkylthiol group having 12 carbon atoms ($-CH_3(CH_2)_{11}SH$). The solid content of the isopropyl alcohol solution of the water-soluble polymer (B-1) was 60 % by mass.

Further, the isopropyl alcohol solution of the water-soluble polymer (B-1) was dried under reduced pressure to obtain a powdery water-soluble polymer (B-2).

The weight average molecular weight of the obtained water soluble polymer (B-2) was 800.

[Production Example 4]

<Water-soluble polymer (B-3)>

50 g of an isopropyl alcohol solution of the water-soluble polymer (B-1) was weighed into a beaker, followed by addition of 25 g of acetone and stirring to obtain a solution of the water-soluble polymer (B-1) in isopropyl alcohol ($\delta$ = 11.5) and acetone ($\delta$ = 9.4). The thus obtained high-polarity solvent solution of the water-soluble polymer (B-1) was transferred to a separatory funnel, and 100 g of heptane ($\delta$ = 7.4) was added thereto as a low-polarity solvent, followed by shaking. The resulting was allowed to stand for 1 hour, to confirm its separation into two layers. The high-polarity solvent layer was separated, concentrated and dried under reduced pressure to obtain 26.4 g of a powdery water-soluble polymer (B-3).

The weight average molecular weight of the obtained water soluble polymer (B-3) was 1,000.

[Production Example 5]

<Water-soluble polymer (B-4)>

5 g of the water-soluble polymer (B-2) was weighed into a beaker, followed by addition of 95 g of ultrapure water and stirring to obtain an aqueous solution of the water-soluble polymer. Further, the aqueous solution of the water-soluble polymer was filtered through a 50 nm polyethylene filter to obtain an aqueous solution of the water-soluble polymer (B-4). The solid content of the aqueous solution of the water-soluble polymer (B-4) was 4.5 % by mass.

The weight average molecular weight of the water-soluble polymer (B-4) was 1,000.

[Production Example 6]

<Water-soluble polymer (B-5)>

5 g of the water-soluble polymer (B-3) was weighed into a beaker, followed by addition of 95 g of ultrapure water and stirring to obtain an aqueous solution of the water-soluble polymer. Further, the aqueous solution of the water-soluble polymer was filtered through a 50 nm polyethylene filter to obtain an aqueous solution of the water-soluble polymer (B-5). The solid content of the aqueous solution of the water-soluble polymer (B-5) was 4.5 % by mass.

The weight average molecular weight of the water-soluble polymer (B-5) was 1,000.

[Production Example 7]

<Water-soluble polymer (B-6)>

50 g of an isopropyl alcohol solution of the water-soluble polymer (B-1) was weighed into a beaker, and redissolved in 5 g of acetone. The resulting solution was dropwise added into 1000 g of n-hexane to obtain a white precipitate, which was separated by filtration, washed with n-hexane and dried to obtain 29 g of a powdery water-soluble polymer (B-6).

The weight average molecular weight of the obtained water soluble polymer (B-6) was 1000.

(Examples 1 to 4, Comparative Examples 1 to 2)

In each of the Examples and Comparative Examples, the conductive polymer (A) obtained in Production Example 1 or 2, the water-soluble polymer (B) obtained in any of Production Examples 3 to 7 and ultrapure water as solvent (C) were mixed together according to the compounding ratio shown in Table 1 to prepare a conductive composition. The amounts of the conductive polymer (A) and the water-soluble polymer (B) in Table 1 are amounts in terms of solid content (part by mass).

The in-liquid particle number of the water-soluble polymer (B), the peak area ratio (Y/(X + Y)), and the evaluation result of filtration time of the conductive composition are shown in Table 1.

[Table 1]

| | | Example 1 | Example 2 | Example 3 | Example 4 | Comparative Example 1 | Comparative Example 2 |
|---|---|---|---|---|---|---|---|
| Conductive Polymer (A) | Type | A-1 | A-1 | A-1 | A-2 | A-1 | A-1 |
| | Amount [Part by mass] | 1.8 | 1.8 | 1.8 | 1.8 | 1.8 | 1.8 |
| Water-soluble Polymer (B) | Type | B-3 | B-4 | B-5 | B-5 | B-2 | B-6 |
| | Amount [Part by mass] | 0.2 | 0.2 | 0.2 | 0.2 | 0.2 | 0.2 |
| Solvent (C) | Type | Ultrapure water | Ultrapure water | Ultrapure water | Ultrapure water | Ultrapure water | Ultrapure water |
| | Amount [Part by mass] | 98 | 98 | 98 | 98 | 98 | 98 |
| In-liquid particle number of water-soluble polymer (B) [Number/ml] | | 4800 | 1500 | 700 | 700 | 12000 | 8000 |
| LC-MS measurement | Area(Y) | $8.38\times10^6$ | $1.63\times10^7$ | $1.42\times10^7$ | $1.42\times10^7$ | $1.65\times10^8$ | $3.01\times10^7$ |
| | Area(X) | $1.13\times10^7$ | $2.16\times10^7$ | $1.95\times10^7$ | $1.95\times10^7$ | $2.00\times10^8$ | $3.53\times10^7$ |
| | Area ratio (Y/(X+Y)) | 0.426 | 0.431 | 0.421 | 0.421 | 0.452 | 0.460 |
| Evaluation of filtration time | | ○ | ○ | ○ | ○ | × | × |

As apparent from Table 1, the results of the Examples revealed that the compositions of the Examples can suppress filter clogging during the filtration and can achieve suppression of filter replacement and reduction of filtration time.

Thus, the conductive composition of the present invention contains less foreign matter and hence allows easy formation of a desired resist pattern when used, for example, as an antistatic film of a resist.

(Examples 5 to 6, Comparative Example 3)

In each of the Examples and Comparative Examples, the conductive polymer (A) obtained in Production Example 1 or 2 and the water-soluble polymer (B) obtained in Production Example 3 or 5 as well as isopropyl alcohol (IPA) and ultrapure water as solvent (C) were mixed together according to the compounding ratio shown in Table 2 to prepare a conductive composition. The amounts of the conductive polymer (A) and the water-soluble polymer (B) in Table 2 are amounts in terms of solid content (part by mass).

Using a pressure filtration apparatus, 10 L of the conductive composition was passed through the filter under a constant pressure of 0.05 MPa by performing a filtration of 1 L each of the conductive composition ten times, and the filtration time per 1 L was measured. As the filter, a nylon filter having a pore size of 40 nm and a membrane area of 2200 $cm^2$ was used. The filtration times in the first filtration and the last (tenth) filtration were measured, and the reduction ratio of the flow rate per unit time and unit membrane area in the first and the tenth filtrations was calculated by the above formulae (II), (II-1) and (II-2). The results are shown in Table 2.

[Table 2]

| | | Example 5 | Example 6 | Comparative Example 3 |
|---|---|---|---|---|
| Conductive polymer (A) | Type | A-1 | A-2 | A-1 |
| | Amount [Part by mass] | 0.45 | 0.45 | 0.45 |

(continued)

| | | Example 5 | Example 6 | Comparative Example 3 |
|---|---|---|---|---|
| Water-soluble (B) | Type | B-4 | B-4 | B-2 |
| | Amount [Part by mass] | 0.05 | 0.05 | 0.05 |
| Solvent (C) | IPA [Part by mass] | 4 | 4 | 4 |
| | Ultrapure water [Part by mass] | 95.5 | 95.5 | 95.5 |
| Filtration time [sec] | 1st filtration | 95 | 740 | 217 |
| | 10th filtration | 100 | 795 | 371 |
| Flow rate reduction [%] | | 5 | 7 | 42 |

As apparent from Table 2, the results of the Examples revealed that the compositions of the Examples can suppress filter clogging during the filtration and can achieve suppression of filter replacement and reduction of filtration time.

Thus, the conductive composition of the present invention contains less foreign matter and hence allows easy formation of a desired resist pattern when used, for example, as an antistatic film of a resist.

Industrial Applicability

The conductive composition of the present invention can be used as an antistatic agent applicable even to the next-generation process for semiconductor devices.

As apparent from Table 1, the results of the Examples revealed that the compositions of the Examples can suppress filter clogging during the filtration and can achieve suppression of filter replacement and reduction of filtration time.

Thus, the conductive composition of the present invention contains less foreign matter and hence allows easy formation of a desired resist pattern when used, for example, as an antistatic film of a resist.

(Examples 5 to 6, Comparative Example 3)

In each of the Examples and Comparative Examples, the conductive polymer (A) obtained in Production Example 1 or 2 and the water-soluble polymer (B) obtained in Production Example 3 or 5 as well as isopropyl alcohol (IPA) and ultrapure water as solvent (C) were mixed together according to the compounding ratio shown in Table 2 to prepare a conductive composition. The amounts of the conductive polymer (A) and the water-soluble polymer (B) in Table 2 are amounts in terms of solid content (part by mass).

Using a pressure filtration apparatus, 10 L of the conductive composition was passed through the filter under a constant pressure of 0.05 MPa by performing a filtration of 1 L each of the conductive composition ten times, and the filtration time per 1 L was measured. As the filter, a nylon filter having a pore size of 40 nm and a membrane area of 2200 $cm^2$ was used. The filtration times in the first filtration and the last (tenth) filtration were measured, and the reduction ratio of the flow rate per unit time and unit membrane area in the first and the tenth filtrations was calculated by the above formulae (II), (II-1) and (II-2). The results are shown in Table 2.

[Table 2]

| | | Example 5 | Example 6 | Comparative Example 3 |
|---|---|---|---|---|
| Conductive polymer (A) | Type | A-1 | A-2 | A-1 |
| | Amount [Part by mass] | 0.45 | 0.45 | 0.45 |
| Water-soluble (B) | Type | B-4 | B-4 | B-2 |
| | Amount [Part by mass] | 0.05 | 0.05 | 0.05 |
| Solvent (C) | IPA [Part by mass] | 4 | 4 | 4 |
| | Ultrapure water [Part by mass] | 95.5 | 95.5 | 95.5 |

(continued)

| | | Example 5 | Example 6 | Comparative Example 3 |
|---|---|---|---|---|
| Filtration time [sec] | 1st filtration | 95 | 740 | 217 |
| | 10th filtration | 100 | 795 | 371 |
| Flow rate reduction [%] | | 5 | 7 | 42 |

As apparent from Table 2, the results of the Examples revealed that the compositions of the Examples can suppress filter clogging during the filtration and can achieve suppression of filter replacement and reduction of filtration time.

Thus, the conductive composition of the present invention contains less foreign matter and hence allows easy formation of a desired resist pattern when used, for example, as an antistatic film of a resist.

Industrial Applicability

The conductive composition of the present invention can be used as an antistatic agent applicable even to the next-generation process for semiconductor devices.

## Claims

**1.** A conductive composition comprising a conductive polymer (A), a water-soluble polymer (B) other than the conductive polymer (A), and a solvent (C),

wherein the conductive polymer (A) is a water-soluble or water-dispersible conductive polymer and has at least one of a sulfonic acid group and a carboxy group,
the water-soluble polymer (B) is a homopolymer of a vinyl monomer having an amide bond, or a compound having a main chain structure formed of a copolymer of a vinyl monomer having an amide bond and a vinyl monomer having no amide bond, and has a terminal hydrophobic group of 4 or more carbon atoms in its molecule,
the solvent (C) is water or a mixed solvent of water and an organic solvent, and
a peak area ratio is 0.44 or less, which is determined in accordance with the section "<High-performance Liquid Chromatograph Mass Spectrometry (LC-MS)>" of the specification based on results of analysis performed using a high performance liquid chromatograph mass spectrometer with respect to a test solution obtained by extracting the water-soluble polymer (B) from the conductive composition with n-butanol, and calculated by formula (I):

$$\text{Area ratio} = Y/(X + Y) \qquad \text{(I)},$$

wherein X is a total peak area of an extracted ion chromatogram prepared with respect to ions derived from compounds having a molecular weight (M) of 600 or more from a total ion current chromatogram, Y is a total peak area of an extracted ion chromatogram prepared with respect to ions derived from compounds having a molecular weight (M) of less than 600 from the total ion current chromatogram.

**2.** The conductive composition according to claim 1, wherein the water-soluble polymer (B) satisfies condition 2: an in-liquid particle number of not more than 5000 particles/ml of liquid as measured with respect to particles having a size of 0.5 to 1 μm in an aqueous solution containing 0.2 % by mass of the water-soluble polymer (B) and 99.8 % by mass of ultrapure water by a liquid particle counter, as determined according to the specification.

**3.** The conductive composition according to claim 1 or 2, wherein the water-soluble polymer (B) has a weight average molecular weight of 600 or more and less than 2000, wherein the weight average molecular weight is measured according to the specification.

**4.** The conductive composition according to any one of claims 1 to 3, wherein the conductive polymer (A) has a monomer unit represented by formula (1):

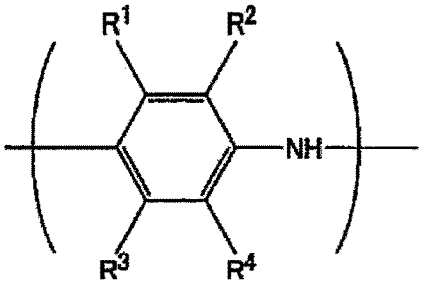

----- (1)

wherein each of $R^1$ to $R^4$ independently represents a hydrogen atom, a linear or branched alkyl group having 1 to 24 carbon atoms, a linear or branched alkoxy group having 1 to 24 carbon atoms, an acidic group, a hydroxy group, a nitro group or a halogen atom (-F, -Cl - Br or I), with the proviso that at least one of $R^1$ to $R^4$ is an acidic group or a salt thereof, and the acidic group is a sulfonic acid group or a carboxylic acid group.

5. The conductive composition according to any one of claims 1 to 4, wherein the water-soluble polymer (B) is a compound represented by formula (2):

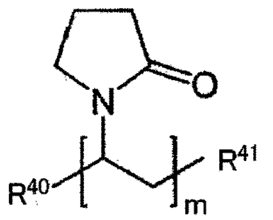

----- (2)

wherein each of $R^{40}$ and $R^{41}$ independently represents an alkylthio group, an aralkylthio group, an arylthio group or a hydrocarbon group, with the proviso that at least one of $R^{40}$ and $R^{41}$ is an alkylthio group, an aralkylthio group or an arylthio group; and m represents an integer of 2 to 100,000.

6. A method for producing the conductive composition of any one of claims 1 to 7, which comprises a step of purifying the water-soluble polymer (B) by at least one of processes (i) and (ii):

(I): a process of washing a solution containing the water-soluble polymer (B) with a solvent, and
(ii): a process of filtering a solution containing the water-soluble polymer (B) through a filter;
wherein the water-soluble polymer (B) is obtained by polymerizing a vinyl monomer having an amide bond in the presence of a polymerization initiator and a chain transfer agent having 4 or more carbon atoms; and
and wherein the step of purifying the water-soluble polymer (B) precedes the mixing of the components of the conductive composition.

7. A method for producing a conductor, which comprises applying the conductive composition of any one of claims 1 to 5 to at least one surface of a substrate to form a coating.

**Patentansprüche**

1. Leitfähige Zusammensetzung, umfassend ein leitfähiges Polymer (A), ein wasserlösliches Polymer (B) außer dem leitfähigen Polymer (A) und ein Lösungsmittel (C),

wobei das leitfähige Polymer (A) ein wasserlösliches oder ein wasserdispergierbares leitfähiges Polymer ist und mindestens eine von einer Sulfonsäuregruppe und einer Carboxygruppe aufweist,
das wasserlösliche Polymer (B) ein Homopolymer von einem Vinylmonomer mit einer Amidbindung oder eine Verbindung mit einer Hauptkettenstruktur ist, die aus einem Copolymer von einem Vinylmonomer mit einer Amidbindung und einem Vinylmonomer, das keine Amidbindung aufweist, gebildet ist, und eine endständige hydrophobe Gruppe aus 4 oder mehr Kohlenstoffatomen in seinem Molekül aufweist,
das Lösungsmittel (C) Wasser oder ein gemischtes Lösungsmittel aus Wasser und einem organischen Lösungsmittel ist und

ein Peakflächenverhältnis 0,44 oder weniger beträgt, das gemäß dem Abschnitt "<Hochleistungsflüssigchromatograph-Massenspektrometrie (LC-MS)>" der Patentschrift basierend auf Ergebnissen einer Analyse, die unter Verwendung eines Hochleistungsflüssigchromatograph-Massenspektrometers bezüglich einer Testlösung durchgeführt wird, die durch Extrahieren des wasserlöslichen Polymers (B) von der leitfähigen Zusammensetzung mit n-Butanol erhalten wird, bestimmt wird und durch Formel (I) berechnet wird:

$$\text{Flächenverhältnis} = Y/(Y + Y) \qquad \text{(I)},$$

worin X eine Gesamtpeakfläche eines extrahierten Ionen-Chromatogramms ist, das bezüglich Ionen erstellt wird, die sich von Verbindungen mit einem Molekulargewicht (M) von 600 oder mehr aus einem Gesamtionenstrom-Chromatogramm ableiten, Y eine Gesamtpeakfläche eines extrahierten Ionen-Chromatogramms ist, das bezüglich Ionen erstellt wird, die sich von Verbindungen mit einem Molekulargewicht (M) von weniger als 600 aus dem Gesamtionenstrom-Chromatogramm ableiten.

**2.** Leitfähige Zusammensetzung gemäß Anspruch 1, wobei das wasserlösliche Polymer (B) Bedingung 2 erfüllt: eine Partikelanzahl in Flüssigkeit von nicht mehr als 5.000 Partikel/ml Flüssigkeit, gemessen bezüglich Partikeln mit einer Größe von 0,5 bis 1 $\mu$m in einer wässrigen Lösung, die 0,2 Masse-% des wasserlöslichen Polymers (B) und 99,8 Masse-% Reinstwasser durch einen Flüssigkeitspartikelzähler, bestimmt gemäß der Patentschrift.

**3.** Leitfähige Zusammensetzung gemäß Anspruch 1 oder 2, wobei das wasserlösliche Polymer (B) ein gewichtsgemitteltes Molekulargewicht von 600 oder mehr und weniger als 2.000 aufweist, wobei das gewichtsgemittelte Molekulargewicht gemäß der Patentschrift gemessen wird.

**4.** Leitfähige Zusammensetzung gemäß einem der Ansprüche 1 bis 3, wobei das leitfähige Polymer (A) eine durch Formel (1) dargestellte Monomereinheit aufweist:

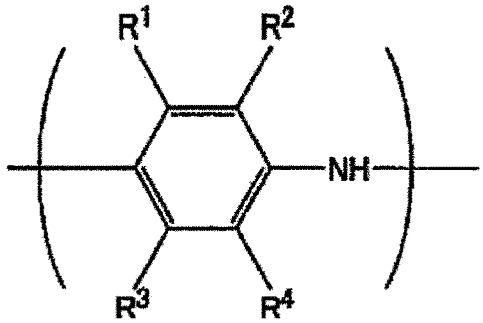

----- (1)

worin jedes von $R^1$ bis $R^4$ unabhängig ein Wasserstoffatom, eine lineare oder verzweigte Alkylgruppe mit 1 bis 24 Kohlenstoffatomen, eine lineare oder verzweigte Alkoxygruppe mit 1 bis 24 Kohlenstoffatomen, eine saure Gruppe, eine Hydroxygruppe, eine Nitrogruppe oder ein Halogenatom (-F, -Cl -Br oder I) darstellt, mit der Maßgabe, dass mindestens eines von $R^1$ bis $R^4$ eine saure Gruppe oder ein Salz davon ist, und die saure Gruppe eine Sulfonsäuregruppe oder eine Carbonsäuregruppe ist.

**5.** Leitfähige Zusammensetzung gemäß einem der Ansprüche 1 bis 4, wobei das wasserlösliche Polymer (B) eine durch Formel (2) dargestellte Verbindung ist:

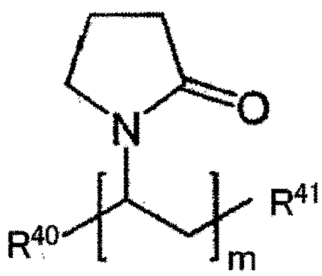

----- (2)

worin jedes von $R^{40}$ und $R^{41}$ unabhängig eine Alkylthiogruppe, eine Aralkylthiogruppe, eine Arylthiogruppe oder eine Kohlenwasserstoffgruppe darstellt, mit der Maßgabe, dass mindestens eines von $R^{40}$ und $R^{41}$ eine Alkylthiogruppe, eine Aralkylthiogruppe oder eine Arylthiogruppe ist, und m eine ganze Zahl von 2 bis 100.000 darstellt.

**6.** Verfahren zur Herstellung der leitfähigen Zusammensetzung gemäß einem der Ansprüche 1 bis 7, das einen Schritt zum Reinigungen des wasserlöslichen Polymers (B) durch mindestens eines der Verfahren (i) und (ii) umfasst:

(I): ein Verfahren zum Waschen einer Lösung, die das wasserlösliche Polymer (B) enthält, mit einem Lösungsmittel und
(ii): ein Verfahren zum Filtrieren einer Lösung, die das wasserlösliche Polymer (B) enthält, durch einen Filter, wobei das wasserlösliche Polymer (B) durch Polymerisieren eines Vinylmonomers mit einer Amidbindung in Gegenwart eines Polymerisationsinitiators und eines Kettenübertragungsmittels mit 4 oder mehr Kohlenstoffatomen erhalten wird, und
und wobei der Schritt zum Reinigen des wasserlöslichen Polymers (B) dem Mischen der Komponenten der leitfähigen Zusammensetzung vorausgeht.

**7.** Verfahren zur Herstellung eines Leiters, das das Auftragen der leitfähigen Zusammensetzung gemäß einem der Ansprüche 1 bis 5 auf mindestens eine Oberfläche eines Substrats zur Bildung einer Beschichtung umfasst.

**Revendications**

**1.** Composition conductrice comprenant un polymère conducteur (A), un polymère soluble dans l'eau (B) autre que le polymère conducteur (A), et un solvant (C),

dans laquelle le polymère conducteur (A) est un polymère conducteur soluble dans l'eau ou dispersible dans l'eau et présente au moins un parmi un groupe acide sulfonique et un groupe carboxy,
le polymère soluble dans l'eau (B) est un homopolymère d'un monomère de vinyle présentant une liaison amide, ou un composé présentant une structure de chaîne principale formée d'un copolymère d'un monomère de vinyle présentant une liaison amide et d'un monomère de vinyle ne présentant pas de liaison amide, et présente un groupe hydrophobe terminal de 4 atomes de carbone ou plus dans sa molécule,
le solvant (C) est de l'eau ou un solvant mélangé d'eau et d'un solvant organique, et
un rapport de surface de pic est de 0,44 ou moins, qui est déterminé conformément à la section "<Chromatographie Liquide-Spectromètre de Masse (LC-MS) à performance élevée>" ("<High-performance Liquid Chromatograph Mass Spectrometry (LC-MS)>") de la description basée sur des résultats d'analyse mise en oeuvre à l'aide d'un spectromètre de masse-chromatographe liquide à performance élevée par rapport à une solution d'essai obtenue en extrayant le polymère soluble dans l'eau (B) de la composition conductrice avec du n-butanol, et calculé par la formule (I) :

$$\text{Rapport de surface} = Y/(X + Y) \qquad (I),$$

dans laquelle X est une surface de pic totale d'un chromatogramme d'ions extraits préparé par rapport à des ions dérivés de composés présentant un poids moléculaire (M) de 600 ou plus à partir d'un chromatogramme de courant ionique total, Y est une surface de pic totale d'un chromatogramme d'ions extraits préparé par rapport à des ions dérivés de composés présentant un poids moléculaire (M) de moins de 600 à partir du chromatogramme de courant ionique total.

**2.** Composition conductrice selon la revendication 1, dans laquelle le polymère soluble dans l'eau (B) satisfait la condition 2 : un nombre de particules dans le liquide de pas plus de 5000 particules/ml de liquide tel que mesuré par rapport à des particules présentant une taille de 0,5 à 1 μm dans une solution aqueuse contenant 0,2 % en masse du polymère soluble dans l'eau (B) et 99,8 % en masse d'eau ultrapure par un compteur de particules de liquide, tel que déterminé selon la description.

**3.** Composition conductrice selon la revendication 1 ou la revendication 2, dans laquelle le polymère soluble dans l'eau (B) présente un poids moléculaire moyen en poids de 600 ou plus et de moins de 2000, dans laquelle le poids moléculaire moyen en poids est mesuré selon la description.

4. Composition conductrice selon l'une quelconque des revendications 1 à 3, dans laquelle le polymère conducteur (A) présente une unité monomère représentée la formule (1) :

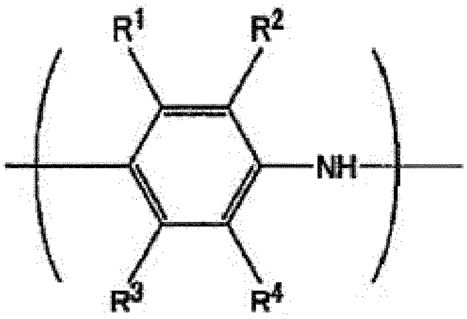

----- (1)

dans laquelle chacun des $R^1$ à $R^4$ représente indépendamment un atome d'hydrogène, un groupe alkyle linéaire ou ramifié présentant 1 à 24 atomes de carbone, un groupe alcoxy linéaire ou ramifié présentant 1 à 24 atomes de carbone, un groupe acide, un groupe hydroxy, un groupe nitro ou un atome d'halogène (-F, -Cl - Br ou I), à la condition qu'au moins un des $R^1$ à $R^4$ soit un groupe acide ou un sel de celui-ci, et que le groupe acide soit un groupe acide sulfonique ou un groupe acide carboxylique.

5. Composition conductrice selon l'une quelconque des revendications 1 à 4, dans laquelle le polymère soluble dans l'eau (B) est un composé représenté par la formule (2) :

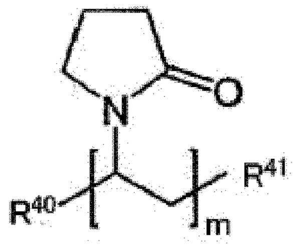

----- (2)

dans laquelle chacun des $R^{40}$ et $R^{41}$ représente indépendamment un groupe alkylthio, un groupe aralkylthio, un groupe arylthio ou un groupe hydrocarbone, à la condition qu'au moins un des $R^{40}$ et $R^{41}$ soit un groupe alkylthio, un groupe aralkylthio ou un groupe arylthio ; et m représente un nombre entier de 2 à 100 000

6. Procédé de production de la composition conductrice selon l'une quelconque des revendications 1 à 7, qui comprend une étape de purification du polymère soluble dans l'eau (B) par au moins un des processus (i) et (ii) :

(I) : un processus de lavage d'une solution contenant le polymère soluble dans l'eau (B) avec un solvant, et
(ii) : un processus de filtrage d'une solution contenant le polymère soluble dans l'eau (B) à travers un filtre,
dans lequel le polymère soluble dans l'eau (B) est obtenu par la polymérisation d'un monomère de vinyle présentant une liaison amide en présence d'un initiateur de polymérisation et un agent de transfert de chaîne présentant 4 atomes de carbone ou plus ; et
et dans lequel l'étape de purification du polymère soluble dans l'eau (B) précède le mélange des composants de la composition conductrice.

7. Procédé de production d'un conducteur, qui comprend l'application de la composition conductrice selon l'une quelconque des revendications 1 à 5 à au moins une surface d'un substrat pour former un revêtement.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2015221871 A
- US 2016091792 A
- JP 2002226721 A
- WO 2014017540 A
- JP 2016188350 A
- JP 2017052886 A
- JP 2014065898 A
- JP 2017101102 A
- JP SHO61197633 A
- JP SHO6339916 A
- JP HEI1301714 A
- JP HEI5504153 A
- JP HEI5503953 A
- JP HEI432848 A
- JP HEI4328181 A
- JP HEI6145386 A
- JP HEI656987 A
- JP HEI5226238 A
- JP HEI5178989 A
- JP HEI6293828 A
- JP HEI7118524 A
- JP HEI632845 A
- JP HEI687949 A
- JP HEI6256516 A
- JP HEI741756 A
- JP HEI748436 A
- JP HEI4268331 A
- JP 7196791 A
- JP HEI7324132 A